# EUROPEAN PATENT APPLICATION

(11) **EP 1 972 701 A1**
(43) Date of publication of application: **24.09.2008**
(21) Application number: 06833784.9
(22) Date of filing: 30.11.2006
(51) Int. Cl.: C23C 14/34, H01L 21/285, H05H 1/48

(54) **SHEET PLASMA FILM FORMING APPARATUS**

(30) Priority: 06.12.2005 JP 2005351615
(71) Applicant: Shinmaywa Industries, Ltd., Takarazuka-shi, Hyogo 665-8550 (JP)
(72) Inventor: MARUNAKA, Masao c/o Research and Development Center, Hyogo 665-8550 (JP); TSUCHIYA, Takayuki c/o Research and Development Center, Hyogo 665-8550 (JP); TERAKURA, Atsuhiro c/o Research and Development Center, Hyogo 665-8550 (JP); TAKEUCHI, Kiyoshi c/o Research and Development Center, Hyogo 665-8550 (JP)
(74) Representative: Piésold, Alexander James
(86) International application number: PCT/JP2006/323981
(87) International publication number: WO 2007/066574

(57) **Abstract**

A sheet plasma film forming apparatus (100) of the present invention includes: a pressure reducing container; a plasma gun (10); an anode (51); plasma flowing means; a sheet plasma converting chamber (20) which is a part of the pressure reducing container; a pair of permanent magnets (24A and 24B) which forms a sheet-shaped plasma; and a film forming chamber (30) which is a part of the pressure reducing container, wherein: the pressure reducing container includes first and second bottle neck portions (29 and 39) that are openings of the film forming chamber (30), and is formed such that the sheet-shaped plasma flows from the sheet plasma converting chamber (20) through the first bottle neck portion (29) to the film forming chamber (30), and the flown sheet-shaped plasma flows through the second bottle neck portion (39) to the anode (51); and in the thickness direction of the sheet-shaped plasma, an internal size of each of the first and second bottle neck portions (29 and 39) is smaller than an internal size of the film forming chamber (30).

## Description

### Technical Field

The present invention relates to a plasma film forming apparatus. More particularly, the present invention relates to a sheet plasma film forming apparatus which uses plasma converted to have a sheet shape.

### Background Art

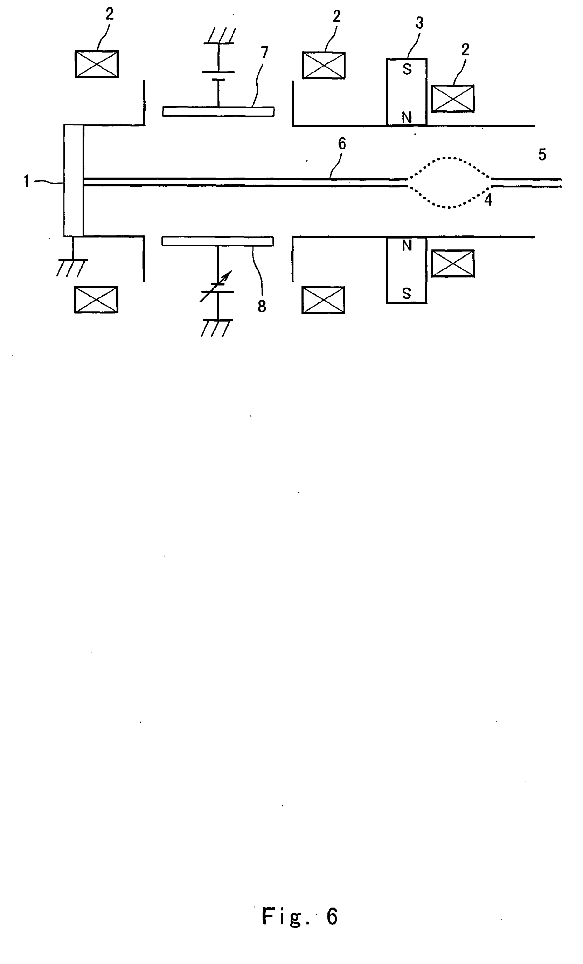

In recent years, as shown in Fig. 6, attention is being given to a sheet plasma film forming apparatus which uses plasma converted to have a sheet shape (hereinafter referred to as "sheet-shaped plasma") by applying a magnetic field generated by a permanent magnet to plasma generated from a plasma source and having a cylindrical shape (hereinafter referred to as "cylindrical plasma") (see Patent Document 1). Specifically, disclosed is a sheet plasma film forming apparatus which converts a cylindrical plasma flow from a cathode side 5 into sheet-shaped plasma 6 by a permanent magnet 3 and introduces the sheet-shaped plasma 6 into an anode 1 using a magnetic field coil 2. In a transfer process of the sheet-shaped plasma 6 in this sheet plasma film forming apparatus, sputter particles are generated from a target 7, and a film is formed on a substrate 8.
To be specific, in the sheet plasma film forming apparatus, the cylindrical plasma emitted from the plasma source is first introduced into a sheet plasma converting chamber at which the permanent magnet is disposed, and the magnetic field by the permanent magnet is applied to the cylindrical plasma. Thus, the sheet-shaped plasma is formed. Then, the sheet-shaped plasma is introduced into, for example, a sputtering chamber in which sputtering is carried out. In the sputtering chamber, the target and the substrate are spaced apart from each other, and the introduced sheet-shaped plasma is interposed between the target and the substrate. In the sputtering chamber, an anode which receives the coming sheet-shaped plasma is disposed. When the sheet-shaped plasma passes through a space between the target and the substrate, it sputters target particles from the target. The target particles which are sputtered from the target and ionized by passing through the sheet-shaped plasma are deposited on the substrate. Thus, a film is formed on the substrate. Then, the sheet-shaped plasma having passed through the space between the target and the substrate is introduced into the anode.
Moreover, also proposed is a sheet plasma film forming apparatus which includes an intermediate electrode having a slit-like opening between the sheet plasma converting chamber and the sputtering chamber (see Patent Document 2).
Patent Document 1: Japanese Laid-Open Patent Application Publication 2005-179767
Patent Document 2: Japanese Laid-Open Patent Application Publication 7-296988

### Disclosure of the Invention

### Problems to be Solved by the Invention

However, the problem of the above sheet plasma film forming apparatus is that surfaces of the target and the substrate are covered with negative electric charge, and a bias voltage cannot be applied to the target and the substrate.
The present invention was made to solve the above problem, and an object of the present invention is to provide a sheet plasma film forming apparatus capable of stably applying the bias voltage to the target and the substrate.

### Means for Solving the Problems

As a result of diligent study on the above problem, the present inventors have found that the sheet-shaped plasma introduced into the sputtering chamber actually spreads around a visible portion (high-density portion) and that if the surfaces of the target and the substrate are subjected to such a spread plasma (low-density portion), the surfaces of the target and the substrate are covered with the negative electric charge. Then, the present inventors have further found that the target and the plasma generating power source, and the substrate and the plasma generating power source short-circuit via the sheet-shaped plasma (conduction state like a circuit), and the bias voltage cannot be applied to the target or the substrate.
In order to solve the above problems, a sheet plasma film forming apparatus of the present invention includes: a pressure reducing container capable of reducing a pressure of an inside thereof; a plasma gun which generates plasma in the pressure reducing container; an anode which receives the plasma in the pressure reducing container; plasma flowing means for converting the plasma generated by the plasma gun into cylindrical plasma and causing the cylindrical plasma to flow toward the anode; a sheet plasma converting chamber which forms a part of the pressure reducing container and is formed such that the cylindrical plasma flows therein; a pair of permanent magnets which are disposed outside the sheet plasma converting chamber such that same polarities thereof are opposed to each other on opposite sides of the flowing plasma, and which convert the cylindrical plasma into a sheet-shaped plasma in the sheet plasma converting chamber; and a film forming chamber which forms a part of the pressure reducing container and in which a substrate holder holding a substrate and a target are opposed to each other on opposite sides of the converted sheet-shaped plasma in a thickness direction of the sheet-shaped plasma, wherein: the pressure reducing container includes first and second bottle neck portions that form openings of the film forming chamber, and is formed such that the sheet-shaped plasma flows from the sheet plasma converting chamber through the first bottle neck portion to the film forming chamber, and the flown sheet-shaped plasma flows through the second bottle neck portion to the anode; and in the thickness direction of the sheet-shaped plasma, an internal size of each of the first and second bottle neck portions is smaller than an internal size of the film forming chamber, and the internal size of the first bottle neck portion is smaller than an internal size of the sheet plasma converting chamber.
With this configuration, the thickness of the low-density portion of the sheet-shaped plasma is regulated by the first and second bottle neck portions, and the spread of the low-density portion in the film forming chamber is suppressed. As a result, by suitably arranging the surfaces of the target and the substrate, the surfaces of the target and the substrate are not subjected to the plasma, and covering of the surfaces of the target and the substrate with the negative electric charge is prevented. Therefore, it is possible to avoid the conduction state like a circuit, and to stably apply the bias voltage to the target and the substrate.

The first bottle neck portion may be formed to have such a cross-sectional shape that the converted sheet-shaped plasma is able to pass through the first bottle neck portion while maintaining a cross-sectional shape of the sheet-shaped plasma.

It is preferable that in the thickness direction of the sheet-shaped plasma, a distance between a transport center of the flowing sheet-shaped plasma and at least one of surfaces of the target and the substrate be longer than each of distances between the transport center of the sheet-shaped plasma and an inner wall of the first bottle neck portion and between the transport center of the sheet-shaped plasma and an inner wall of the second bottle neck portion.

It is preferable that the distance between the transport center of the sheet-shaped plasma and at least one of the surfaces of the target and the substrate be not less than 10 mm and not more than 200 mm.

With this configuration, it is possible to prevent the surfaces of the target and the substrate from being subjected to the sheet-shaped plasma.

It is preferable that in the thickness direction of the sheet-shaped plasma, the internal size of the first bottle neck portion be smaller than a sum of a distance between a transport center of the sheet-shaped plasma and a surface of the target and a distance between the transport center of the sheet-shaped plasma and a surface of the substrate, and be not less than 10 mm and not more than 100 mm.

The sheet plasma film forming apparatus may further include a movement mechanism which causes at least one of the target and the substrate to move in the thickness direction of the sheet-shaped plasma.

With this configuration, it is possible to adjust the distances between the target and the sheet-shaped plasma and between the substrate and the sheet-shaped plasma. Therefore, it is possible to accurately prevent the surfaces of the target and the substrate from being subjected to the sheet-shaped plasma. On this account, it is possible to stably apply the bias voltage to the target and the substrate.
The above object, other objects, features, and advantages of the present invention will be made clear by the following detailed explanation of a preferred embodiment with reference to the attached drawings.

### Effects of the Invention

The present invention is configured as above, and has effects of suppressing the covering of the target surface and the substrate surface with the negative electric charge and being able to stably apply the bias voltage to the target and the substrate in the sheet plasma film forming apparatus.

### Brief Description of the Drawings

[Fig. 1] Fig. 1 is a schematic diagram showing the configuration of a sheet plasma film forming apparatus according to an embodiment of the present invention.
[Figs. 2] Figs. 2 are diagrams showing the configuration of a film forming chamber in the sheet plasma film forming apparatus of the present embodiment. Fig. 2(a) is a front view of the film forming chamber, and Fig. 2(b) is a cross-sectional view taken along line IIB-IIB of the film forming chamber of Fig. 2(a).
[Figs. 3] Figs. 3 are schematic diagrams for schematically explaining a method for forming sheet-shaped plasma. Fig. 3(a) is a schematic diagram of a cross section which is in parallel with an X-Y plane in the vicinity of a Z-direction center of a permanent magnet, and Fig. 3(b) is a schematic diagram of a cross section which is in parallel with a Y-Z plane in the vicinity of an X-direction center of the permanent magnet.
[Fig. 4] Fig. 4 is a plan view showing the sheet-shaped plasma formed by the sheet plasma film forming apparatus of Fig. 1.
[Fig. 5] Fig. 5 is a perspective view showing the sheet-shaped plasma formed by the sheet plasma film forming apparatus of Fig. 1.
[Fig. 6] Fig. 6 is a schematic diagram showing the configuration of a conventional sheet plasma film forming apparatus.

### Explanation of Reference Numbers

- 10: plasma gun
- 11: flange
- 12: cathode
- 13: first magnet coil
- 14: discharge space
- 15: insulator
- 17: tubular member
- 18,32: exhaust port
- 20: sheet plasma converting chamber
- 21: transport space
- 22: cylindrical plasma
- 23: second magnet coil (plasma flowing means)
- 24A, 24B: permanent magnet
- 25, 38: vacuum pump
- 26, 37: valve
- 27(S): sheet plasma
- 28: third magnet coil (plasma flowing means)
- 29: first bottle neck portion
- 30: film forming chamber
- 31: film forming space
- 33A: target
- 33B: target holder
- 33C, 34C: cylindrical rotary shaft (rotary shaft)
- 34A: substrate
- 34B: substrate holder
- 35, 36: movement mechanism
- 39: second bottle neck portion
- 40: chamber
- 42: first opening
- 43: flange
- 45: second opening
- 48: fourth magnet coil (plasma flowing means)
- 50: anode chamber
- 51: anode
- 52: permanent magnet
- 100: sheet plasma film forming apparatus
- G₁: first intermediate electrode
- G₂: second intermediate electrode
- P: transport center
- S: main surface
- V₁: main DC power source
- V₂, V₃: DC power source

### Best Mode for Carrying Out the Invention

Hereinafter, an embodiment of the present invention will be explained with reference to the drawings.

### Embodiment

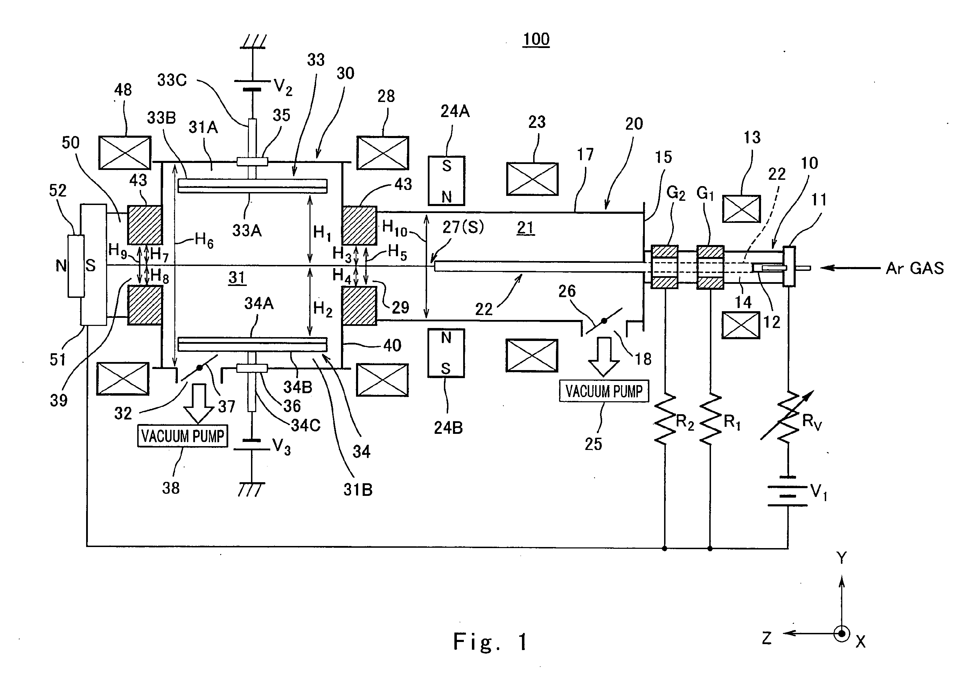

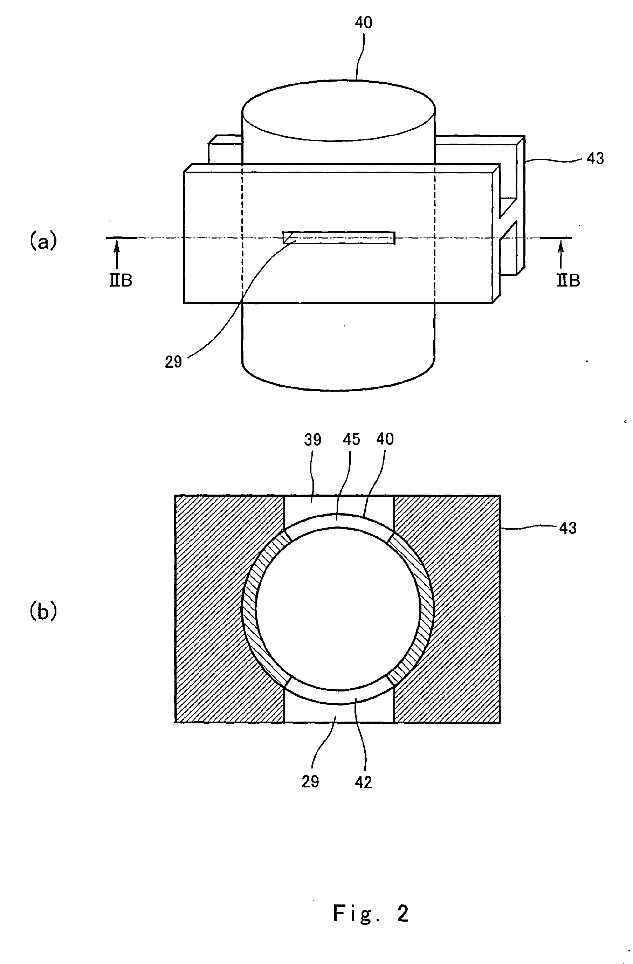

Fig. 1 is a schematic diagram showing one example of the configuration of a sheet plasma film forming apparatus of an embodiment of the present invention. Figs. 2 are diagrams showing the configuration of a film forming chamber in the sheet plasma film forming apparatus of Fig. 1. Fig. 2(a) is a front view of the film forming chamber, and Fig. 2(b) is a cross-sectional view taken along line IIB-IIB of the film forming chamber of Fig. 2(a). Hereinafter, the sheet plasma film forming apparatus according to the present embodiment will be explained with reference to Figs. 1 and 2. For convenience sake, the configuration of the sheet plasma film forming apparatus will be explained on the basis that as shown in Fig. 1, a direction of plasma transport is a Z direction, a direction which is orthogonal to the Z direction and is a magnetization direction of permanent magnets 24A and 24B (will be described later) is a Y direction, and a direction which is orthogonal to both the Z direction and the Y direction is an X direction.

A sheet plasma film forming apparatus 100 of the present embodiment includes a pressure reducing container capable of reducing the pressure of an inside thereof. The pressure reducing container capable of reducing the pressure of the inside thereof is comprised of a below-described sheet plasma converting chamber 20, film forming chamber 30, anode chamber 50, first bottle neck portion 29 and second bottle neck portion 39.
As shown in Fig. 1, the sheet plasma film forming apparatus 100 of the present embodiment has a substantially cross shape in a Y-Z plane. The sheet plasma film forming apparatus 100 of the present embodiment is configured to include a plasma gun 10 which forms plasma densely, the cylindrical sheet plasma converting chamber 20 whose center axis conforms to an axis extending in the Z direction, and a cylindrical film forming chamber 30 whose center axis conforms to an axis extending in the Y direction, which are arranged in this order when viewed from the plasma transport direction (Z direction). Note that these members 10, 20 and 30 are air-tightly in communication with one another via passages for transporting plasma.

The plasma gun 10 includes a discharge space 14 which can be reduced in pressure. A flange 11 is disposed on a Z-direction first end of the plasma gun 10 so as to close the discharge space 14. On the flange 11, a cathode 12 which emits thermoelectron for plasma discharge induction is disposed. Moreover, on the flange 11, gas introducing means (not shown) for introducing an argon (Ar) gas as a discharge gas to be ionized by this discharge to the discharge space 14 is disposed. The cathode 12 is connected to a negative terminal of a main DC power source V₁ with a resistor R_{V} disposed therebetween, and a below-described anode 51 is connected to a positive terminal of the main DC power source V₁. The plasma gun 10 includes a first intermediate electrode G₁ and a second intermediate electrode G₂. The first intermediate electrode G₁ is connected to the positive terminal of the main DC power source V₁ via a resistor R₁. The second intermediate electrode G₂ is connected to the positive terminal of the main DC power source V₁ via a resistor R₂. To maintain the plasma discharge (glow discharge) between the cathode 12 and the anode 51, a predetermined positive voltage is applied by a combination of the main DC power source V₁ and the suitable resistors R_{V}, R₁ and R₂. By such plasma discharge, plasma as an assembly of charged particles (here, Ar⁺ and electrons) is formed in the discharge space 14 of the plasma gun 10. Note that adopted herein is the plasma gun 10 of a known pressure gradient type which realizes the high-density plasma discharge between the cathode 12 and the below-described anode 51 by DC arc discharge of low voltage and large current based on the main DC power source V₁.

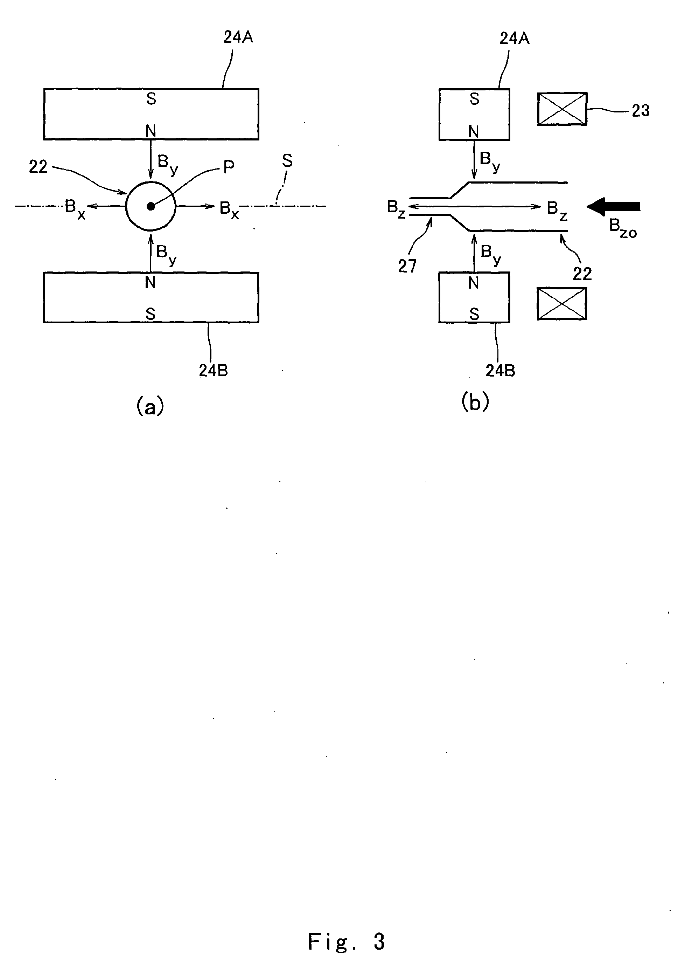

Around the plasma gun 10, an annular first magnet coil 13 is disposed so as to surround the circumference of a side surface of the plasma gun 10. By supplying a current to a winding wire of the first magnet coil 13, a Z-direction gradient of a magnetic flux density based on a coil magnetic field is formed in the discharge space of the plasma gun 10. The Z-direction gradient of the magnetic flux density causes the charged particles constituting the plasma to proceed in the Z direction while circling around the line of magnetic force such that the charged particles move in the Z direction (direction toward the anode 51) from the discharge space. Then, as cylindrical source plasma (hereinafter referred to as "cylindrical plasma 22") which distributes at a substantially uniform density with respect to a transport center P (see Fig. 3) in the Z direction, the plasma as an assembly of the charged particles is drawn to the sheet plasma converting chamber 20 via a passage (not shown) extending between a Z-direction second end of the plasma gun 10 and a Z-direction first end of the sheet plasma converting chamber 20.

The sheet plasma converting chamber 20 is disposed on the Z-direction second end of the plasma gun 10. The plasma gun 10 and the sheet plasma converting chamber 20 are connected to each other via an insulator 15. The sheet plasma converting chamber 20 includes a tubular member 17. The tubular member 17 includes therein a cylindrical transport space 21 whose center axis conforms to an axis extending in the Z direction. The tubular member 17 is made of a non-magnetic material, such as glass or stainless steel. The shape of a cross section of the tubular member 17 which section is in parallel with the X-Y plane is, for example, a circular shape or a quadrangle, and is the circular shape in the present embodiment. A pair of permanent magnets 24A and 24B are disposed outside the tubular member 17. The pair of permanent magnets 24A and 24B are disposed such that a north pole of the permanent magnet 24A and a north pole of the permanent magnet 24B are opposed to each other with the tubular member 17 disposed therebetween in the Y direction. A second magnet coil (plasma flowing means) 23 and a third magnet coil (plasma flowing means) 28 are disposed on both sides of the permanent magnets 24A and 24B in a length direction of the tubular member 17. The second magnet coil 23 is used to draw the cylindrical plasma 22 from the plasma gun 10 to the tubular member 17. The second magnet coil 23 and the third magnet coil 28 are used to arrange the shape of a below-described sheet-shaped plasma 27 in a width direction (X direction). An exhaust port 18 for carrying out vacuuming of the transport space 21 of the tubular member 17 is disposed on an appropriate position of the tubular member 17. The exhaust port 18 is configured to be openable and closable by a valve 26. A vacuum pump 25 is connected to the exhaust port 18. The vacuum pump 25 quickly reduces the pressure of the transport space 21 to a level that the cylindrical plasma 22 can be transported.

As shown in Fig. 1, when the cylindrical plasma 22 emitted from the plasma gun 10 proceeds up to a position of the transport space 21 where the permanent magnets 24A and 24B are disposed, it is converted into a sheet shape (sheet-shaped plasma 27) by a magnetic field formed by the permanent magnets 24A and 24B. The shape of the sheet-shaped plasma 27 in the width direction (X direction) is regulated by the third magnet coil 28. The formed sheet-shaped plasma 27 is introduced into the below-described anode 51. A method for forming the sheet-shaped plasma 27 will be explained later in detail.

A Z-direction front end of the sheet plasma converting chamber 20 is coupled to the film forming chamber 30. Adopted as the film forming chamber 30 is, for example, a vacuum sputtering apparatus which dislodges sputter particles from a target 33A by a collision energy of Ar⁺ (argon ions) in the sheet-shaped plasma 27.

As shown in Figs. 2(a) and 2(b), the film forming chamber 30 includes a cylindrical chamber 40. The chamber 40 is made of a non-magnetic material, such as stainless steel. The chamber 40 has a first opening 42 at its substantially intermediate position in a height direction (Y direction). A flange 43 is disposed on the first opening 42 so as to join the first opening 42. The sheet plasma converting chamber 20 and the film forming chamber 30 are coupled to each other via the first opening 42 and the flange 43 which are formed on a side wall of the chamber 40. To be specific, the sheet plasma converting chamber 20 and the film forming chamber 30 are connected to each other via a bottle neck portion (first bottle neck portion) 29 formed by the first opening 42 and the flange 43. Note that an internal space of the first bottle neck portion 29 has a rectangular cross section which is long in the X direction and has a square pole shape extending in the Z direction. The height (Y-direction internal size H₅) and width (X-direction internal size) of the internal space of the first bottle neck portion 29 are designed such that the sheet-shaped plasma 27 can appropriately pass through the internal space of the first bottle neck portion 29. For example, the height of the internal space of the first bottle neck portion 29 is 40 mm in the present embodiment. The width of the internal space of the first bottle neck portion 29 is larger than the width of the sheet-shaped plasma 27 to be formed. To be specific, the internal space of the first bottle neck portion 29 is formed to have such a size that the sheet-shaped plasma 27 to be formed can pass through the opening.

The chamber 40 includes therein a film forming space 31. In the following explanation, the film forming space 31 will be explained by being functionally divided, by a center space which corresponds to the internal space of the first bottle neck portion 29 and extends along a horizontal surface (X-Z plane), into a target space 31A defined by an enclosing portion storing the below-described target 33A and a substrate space 31B defined by an enclosing portion storing a below-described substrate 34A, in the vertical direction (Y direction). Note that the center space is a space in the film forming chamber 30 where the high-density portion of the sheet plasma 27 is transported.

In the target space 31A, a target holder 33 holding the target 33A is disposed. The target holder 33 includes a disc-like holder 33B. A cylindrical rotary shaft 33C extending in the Y direction is connected to the holder 33B. The rotary shaft 33C is inserted through a through hole (not shown) formed on the chamber 40. The rotary shaft 33C is connected to a movement mechanism 35 so that the target holder 33 is movable in the Y direction. As the movement mechanism 35, a known mechanism can be used. The rotary shaft 33C is air-tightly disposed on the chamber 40 so that the degree of vacuum of the film forming space 31 in the film forming chamber 30 can be maintained. Moreover, the rotary shaft 33C is insulated from the film forming chamber 30 (chamber 40) such that the rotary shaft 33C and the film forming chamber 30 do not short-circuit. A DC power source V₂ is connected to the target holder 33. The DC power source V₂ applies a negative bias voltage to the target holder 33. The target 33A is made of copper in the present embodiment. The target 33A may be made of the other material depending on a film formed on the below-described substrate 34A.

Moreover, in the substrate space 31B, a substrate holder 34 holding the substrate 34A is disposed. The substrate holder 34 includes a disc-like holder 34B. A cylindrical rotary shaft 34C extending in the Y direction is connected to the holder 34B. The rotary shaft 34C is inserted through a through hole (not shown) formed on the chamber 40. The rotary shaft 34C is connected to a movement mechanism 36 so that the substrate holder 34 is movable in the Y direction. As the movement mechanism 36, a known mechanism can be used. The substrate holder 34 is disposed so as to be opposed to (to be in parallel with) the target holder 33 with the formed sheet-shaped plasma 27 interposed therebetween. The rotary shaft 34C is air-tightly disposed on the chamber 40 so that the degree of vacuum of the film forming space 31 in the film forming chamber 30 can be maintained. Moreover, the rotary shaft 34C is insulated from the film forming chamber 30 (chamber 40) such that the rotary shaft 34C and the film forming chamber 30 do not short-circuit. A DC power source V₃ is connected to the substrate holder 34. The DC power source V₃ applies a negative bias voltage to the substrate holder 34.

An exhaust port 32 for carrying out vacuuming of the film forming space 31 in the chamber 40 is disposed on an appropriate position of the chamber 40. The exhaust port 32 is configured to be openable and closable by a valve 37. A vacuum pump 38 is connected to the exhaust port 32. The vacuum pump 38 quickly reduces the pressure of the film forming space 31 to a level that the sheet-shaped plasma 27 can be transported.

A second opening 45 is formed at a rear end (Z direction) of the chamber 40 of the film forming chamber 30 (see Fig. 2). The flange 43 is disposed on the second opening 45 so as to be joined to the second opening 45. The film forming chamber 30 and the below-described anode chamber 50 are coupled to each other via the second opening 45 and the flange 43. To be specific, the film forming chamber 30 and the anode chamber 50 are connected to each other via a bottle neck portion (second bottle neck portion) 39 formed by the second opening 45 and the flange 43. Note that the height (Y-direction internal size H₉) and width (X-direction internal size) of an internal space of the second bottle neck portion 39 are designed such that the sheet-shaped plasma 27 can appropriately pass through the internal space of the second bottle neck portion 39. For example, the height of the internal space of the second bottle neck portion 39 is 40 mm in the present embodiment. The width of the internal space of the second bottle neck portion 39 is larger than the width of the sheet-shaped plasma 27 to be formed. To be specific, the internal space of the second bottle neck portion 39 is formed to have such a size that the sheet-shaped plasma 27 to be formed can pass through the opening. A fourth magnet coil (plasma flowing means) 48 is disposed around the second bottle neck portion 39. The fourth magnet coil 48 is used to arrange the shape of the formed sheet-shaped plasma 27 in the width direction.

The anode chamber 50 includes a tubular body. The anode chamber 50 is configured such that a first end of the tubular body is connected to the flange 43, and a second end of the tubular body is closed by the anode 51. The tubular body and the anode 51 are connected to each other via an insulating material (not shown). A permanent magnet 52 is disposed on a rear surface of the anode 51. The permanent magnet 52 is disposed such that a south pole thereof contacts the anode 51. The permanent magnet 52 arranges the shape of a Z-direction tail end of the sheet-shaped plasma 27.

The sheet plasma film forming apparatus 100 of the present embodiment includes a control device (not shown). The control device controls operations of the vacuum pumps 25 and 38, the main DC power source V₁, the DC power sources V₂ and V₃, etc.

The following will explain a relation between the Y-direction internal sizes of the first bottle neck portion 29 and the second bottle neck portion 39 and the Y-direction internal sizes of the sheet plasma converting chamber 20 and the film forming chamber 30, which is a feature of the present invention.

As shown in Fig. 1, in the present embodiment, the Y-direction internal size H₅ of the first bottle neck portion 29 is configured to be smaller than the Y-direction internal size H₁₀ of the sheet plasma converting chamber 20. Moreover, the Y-direction internal size H₅ of the first bottle neck portion 29 is configured to be smaller than the Y-direction internal size H₆ of the film forming chamber 30. With this configuration, the thickness of the low-density portion of the sheet-shaped plasma 27 transported into the film forming chamber 30 is regulated by the first bottle neck portion 29. Thus, the Y-direction spread of the low-density portion in the film forming chamber 30 is regulated. This effect increases as the difference between the Y-direction internal size H₅ of the first bottle neck portion 29 and the Y-direction internal size H₁₀ of the sheet plasma converting chamber 20 and the difference between the Y-direction internal size H₅ of the first bottle neck portion 29 and the Y-direction internal size H₆ of the film forming chamber 30 increase. Therefore, it is preferable that these differences be large. Specifically, it is preferable that the Y-direction internal size H₅ of the first bottle neck portion 29 be smaller than a sum (H₁ + H₂) of a distance between the transport center P of the sheet-shaped plasma 27 and the surface of the target 33A and a distance between the transport center P of the sheet-shaped plasma 27 and the surface of the substrate 34A, and be not less than 10 mm and not more than 100 mm.

As shown in Fig. 1, in the present embodiment, the Y direction internal size H₉ of the second bottle neck portion 39 is configured to be smaller than the Y-direction internal size H₆ of the film forming chamber 30. Moreover, it is preferable that a difference between the Y direction internal size H₉ of the second bottle neck portion 39 and the Y-direction internal size H₆ of the film forming chamber 30 be large. With this configuration, the Y-direction spread of the low-density portion of the sheet-shaped plasma 27 in the film forming chamber 30 is regulated. By the combination of the effect obtained by the first bottle neck portion 29 and the effect obtained by the second bottle neck portion 39, the Y-direction spread of the low-density portion of the sheet-shaped plasma 27 is further regulated.

As a rule of thumb, it has already been found that that in the sheet plasma film forming apparatus 100 of the present embodiment, by setting a distance between the high-density portion (visible portion) of the sheet-shaped plasma 27 and the target 33A and a distance between the high-density portion (visible portion) of the sheet-shaped plasma 27 and the substrate 34A to be 20 mm, the sheet-shaped plasma 27 and the target 33A, and the sheet-shaped plasma 27 and the substrate 34A do not conduct like a circuit. Therefore, it is preferable that the distance H₁ between the transport center P of the sheet-shaped plasma 27 and the surface of the target 33A be longer than a distance H₃ between the transport center P of the sheet-shaped plasma 27 and an inner wall of the first bottle neck portion 29, and be not less than 10 mm and not more than 200 mm. Moreover, it is preferable that the distance H₂ between the transport center P of the sheet-shaped plasma 27 and the surface of the substrate 34A be longer than a distance H₄ between the transport center P of the sheet-shaped plasma 27 and the inner wall of the first bottle neck portion 29, and be not less than 10 mm and not more than 200 mm. Further, it is preferable that the distance H₁ between the transport center P of the sheet-shaped plasma 27 and the surface of the target 33A be longer than a distance H₇ between the transport center P of the sheet-shaped plasma 27 and an inner wall of the second bottle neck portion 39. Furthermore, it is preferable that the distance H₂ between the transport center P of the sheet-shaped plasma 27 and the surface of the substrate 34A be longer than a distance H₈ between the transport center P of the sheet-shaped plasma 27 and the inner wall of the second bottle neck portion 39.

Hereinafter, a method for converting the cylindrical plasma 22 into the sheet-shaped plasma 27 based on a magnetic field interaction generated by the second magnet coil 23 and the pair of permanent magnets 24A and 24B will be explained in detail with reference to Fig. 3.

Figs. 3 are schematic diagrams for schematically explaining a method for forming the sheet-shaped plasma 27 formed by the sheet plasma film forming apparatus 100 shown in Fig. 1. Fig. 3(a) is a schematic diagram of a cross section which is in parallel with the X-Y plane in the vicinity of the Z-direction center of the permanent magnets 24A and 24B, and Fig. 3(b) is a schematic diagram of a cross section which is in parallel with the Y-Z plane in the vicinity of the X-direction center of the permanent magnets 24A and 24B.

In Figs. 3, Bx denotes a magnetic flux density vector component in the X direction of Fig. 1, By denotes a magnetic flux density vector component in the Y direction of Fig. 1, and Bz denotes a magnetic flux density vector component in the Z direction of Fig. 1.

As shown in Fig. 3(b), by the magnetic field of the second magnet coil 23, an initial magnetic flux density component Bz0 is generated, which acts in the Z direction on the cylindrical plasma 22 which has not yet reached the permanent magnets 24A and 24B. Here, it is necessary to set the position of the second magnet coil 23 and the amount of current supplied to the winding wire of the second magnet coil 23 so that a magnitude correlation between the initial magnetic flux density component Bz0 and a Z-direction magnetic flux density component Bz formed by the pair of permanent magnets 24A and 24B is appropriately maintained. It is thought that if the magnitude correlation therebetween is not appropriately maintained, the shape of the plasma is distorted (for example, the generation of so-called horn) when converting the cylindrical plasma 22 into the sheet-shaped plasma 27, so that it becomes difficult to uniformly spread the cylindrical plasma 22 along a main surface S.

Next, as shown in Fig. 3(a), a pair of Y-direction magnetic flux density components By are formed on the X-Y plane so as to approach to the transport center P from north pole surfaces of the pair of permanent magnets 24A and 24B. Moreover, a pair of X-direction magnetic flux density components Bx are formed so as to proceed in parallel with the north pole surfaces of the permanent magnets 24A and 24B and to move away from each other from the transport center P.

Since the north pole surfaces of the permanent magnets 24A and 24B are disposed so as to be opposed to each other, the pair of Y-direction magnetic flux density components By are canceled each other as they approach to the transport center P from the north pole surfaces. Thus, a suitable negative gradient can be given to the Y-direction magnetic flux density components.

As shown by arrows of Fig. 3(a), such gradient of the Y-direction magnetic flux density components By causes the charged particles to move in the Y direction toward the transport center P such that the cylindrical plasma 22 is compressed. With this, the charged particles in the cylindrical plasma 22 proceed toward the transport center P while circling around the line of magnetic force.

Meanwhile, by appropriately designing the positions of the permanent magnets 24A and 24B and the strength of the magnetic field generated by the permanent magnets 24A and 24B, the pair of X-direction magnetic flux density component Bx can be adjusted such that a suitable negative gradient is given to the X-direction magnetic flux density components as the X-direction magnetic flux density components proceed in the X direction so as to move away from each other from the transport center P.

As shown by arrows of Fig. 3(a), such gradient of the X-direction magnetic flux density components Bx causes the charged particles to move such that the cylindrical plasma 22 spreads along the main surface S (X-Z plane). With this, the charged particles in the cylindrical plasma 22 proceed so as to move away from the transport center P while circling around the line of magnetic force.

Thus, while moving in the sheet plasma converting chamber 20 in the Z direction, the cylindrical plasma 22 is uniformly converted into the sheet-shaped plasma 27 spreading along the main surface S based on the magnetic field interaction generated by the second magnet coil 23 and the permanent magnets 24A and 24B. Note that the width and thickness of the sheet-shaped plasma 27, the density distribution of the charged particles, etc. are adjustable by suitably changing the magnetic flux densities Bx, By, Bz and Bz0.

As shown in Fig. 1, the sheet-shaped plasma 27 converted as above is drawn to the film forming chamber 30 via the slit-like first bottle neck portion 29 through which the sheet-shaped plasma 27 passes, which portion 29 is disposed between a Z-direction second end of the sheet plasma converting chamber 20 and a side wall of the film forming chamber 30.

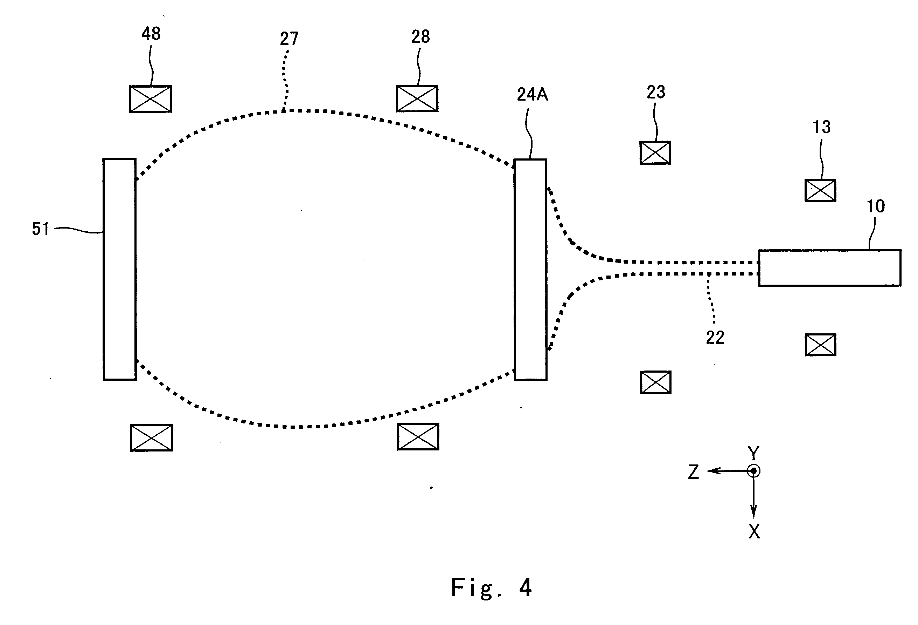

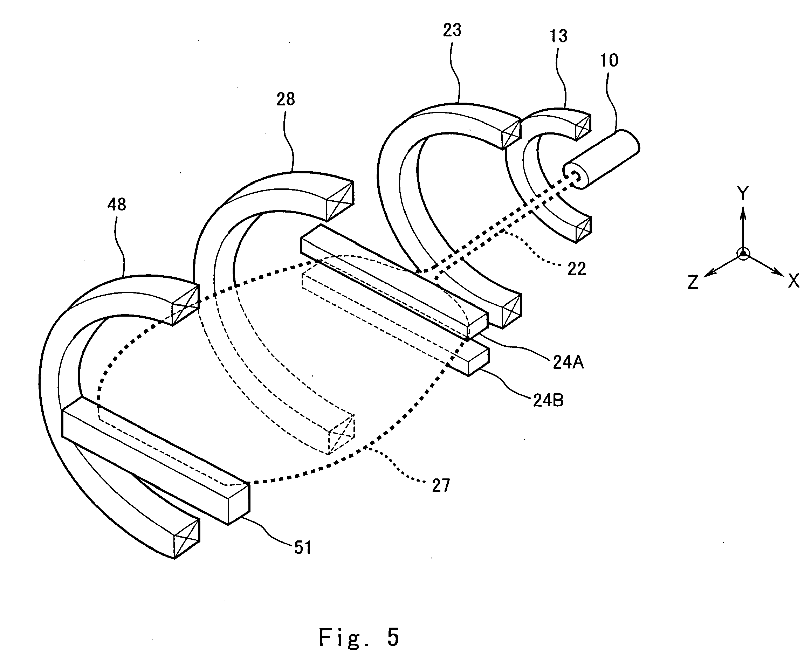

The sheet-shaped plasma 27 formed as above will be explained visually. Fig. 4 is a plan view of the sheet-shaped plasma 27 formed in the sheet plasma film forming apparatus 100 of Fig. 1. Fig. 5 is a perspective view of the sheet-shaped plasma 27 formed in the sheet plasma film forming apparatus 100 of Fig. 1.

As shown in Figs. 4 and 5, the cylindrical plasma 22 is emitted from the plasma gun 10 in the Z direction. The cylindrical plasma 22 is transported by the first magnet coil 13 and the second magnet coil 23 up to a position where the permanent magnets 24A and 24B are disposed. As described above, by the magnetic field generated by the permanent magnets 24A and 24B, the cylindrical plasma 22 is converted into the sheet-shaped plasma 27 spreading along the X-Z plane. The sheet-shaped plasma 27 is transported to the anode 51 by the third magnet coil 28 and the fourth magnet coil 48.

Next, operations of the sheet plasma film forming apparatus 100 of the present embodiment will be explained. Note that the sheet plasma film forming apparatus 100 includes the control device as described above, and the control device carries out the following operations.

First, in the sheet plasma film forming apparatus 100 of the present embodiment, the vacuum pump 25 operates so as to carry out vacuuming of the inside of the sheet plasma converting chamber 20. Moreover, the vacuum pump 38 operates so as to carry out vacuuming of the inside of the film forming chamber 30.

Next, the argon gas is supplied to the cathode 12, and the cathode 12 emits the cylindrical plasma 22 containing the argon ions. The emitted cylindrical plasma 22 is introduced into the sheet plasma converting chamber 20. The introduced cylindrical plasma 22 is transported by the second magnet coil 23 up to a position of the sheet plasma converting chamber 20 where the permanent magnets 24A and 24B are disposed. The transported cylindrical plasma 22 is converted into the sheet-shaped plasma 27 by being compressed by the magnetic field generated by the north pole of the permanent magnet 24A and the north pole of the permanent magnet 24B. The converted sheet-shaped plasma 27 is transported from the sheet plasma converting chamber 20 through the first bottle neck portion 29 to the film forming chamber 30.

In the film forming chamber 30, the negative bias voltage is applied from the DC power source V₂ through the target holder 33 to the target 33A. Meanwhile, the negative bias voltage is applied from the DC power source V₃ through the substrate holder 34 to the substrate 34A. Since the target 33A is charged by the negative bias, the argon ions in the sheet-shaped plasma 27 are attracted to the target 33A. The argon ions attracted to the target 33A sputter copper atoms in the target 33A. The sputtered copper atoms pass through the sheet-shaped plasma 27 in the thickness direction while being converted into copper ions by the sheet-shaped plasma 27. The copper ions are deposited on the surface of the substrate 34A to form a film.
Next, characteristic operations of the sheet plasma film forming apparatus 100 of the present embodiment will be explained.
In the sheet plasma film forming apparatus 100 of the present embodiment, the sheet plasma converting chamber 20 and the film forming chamber 30 are connected to each other via the first bottle neck portion 29, and the film forming chamber 30 and the anode chamber 50 are connected to each other via the second bottle neck portion 39. Therefore, the thickness of the low-density portion of the sheet-shaped plasma 27 is regulated by the first bottle neck portion 29 and the second bottle neck portion 39. On this account, the spread of the low-density portion in the film forming chamber 30 is suppressed, the surface of the target 33A and the surface of the substrate 34A are not subjected to the low-density portion of the sheet-shaped plasma 27, and the surface of the target 33A and the surface of the substrate 34A are not covered with the negative electric charge. Therefore, it is possible to avoid the conduction state like a circuit, and to stably apply the bias voltage to the target 33A and the substrate 34A.

Moreover, since the sheet plasma film forming apparatus 100 of the present embodiment includes the movement mechanisms 35 and 36 which allow the target holder 33 and the substrate holder 34 to move upward and downward, a distance between the sheet-shaped plasma 27 and the target 33A and a distance between the sheet-shaped plasma 27 and the substrate 34A are variable. Therefore, in a case where the distance between the sheet-shaped plasma 27 and the target 33A and the distance between the sheet-shaped plasma 27 and the substrate 34A are too short, the distances can be increased, so that the target 33A and the substrate 34A are appropriately positioned outside the range of the low-density portion of the sheet-shaped plasma 27. Therefore, the target 33A and the substrate 34A are not subjected to the low-density portion of the sheet-shaped plasma 27. On this account, it is possible to accurately avoid the conduction state like a circuit, and to stably apply the bias voltage to the target 33A and the substrate 34A.
From the foregoing explanation, many modifications and other embodiments of the present invention are obvious to one skilled in the art. Therefore, the foregoing explanation should be interpreted only as an example, and is provided for the purpose of teaching the best mode for carrying out the present invention to one skilled in the art. The structures and/or functional details may be substantially modified within the spirit of the present invention.

### Industrial Applicability

The sheet plasma film forming apparatus according to the present invention is useful as a sheet plasma film forming apparatus which suppresses covering of the target surface and the substrate surface with negative electric charge, and can stably apply the bias voltage to the target and the substrate.

## Claims

1. A sheet plasma film forming apparatus comprising:
a pressure reducing container capable of reducing a pressure of an inside thereof;
a plasma gun which generates plasma in the pressure reducing container;
an anode which receives the plasma in the pressure reducing container;
plasma flowing means for converting the plasma generated by the plasma gun into cylindrical plasma and causing the cylindrical plasma to flow toward the anode;
a sheet plasma converting chamber which forms a part of the pressure reducing container and is formed such that the cylindrical plasma flows therein;
a pair of permanent magnets which are disposed outside the sheet plasma converting chamber such that same polarities thereof are opposed to each other on opposite sides of the flowing plasma, and which convert the cylindrical plasma into a sheet-shaped plasma in the sheet plasma converting chamber; and
a film forming chamber which forms a part of the pressure reducing container and in which a substrate holder holding a substrate and a target are opposed to each other on opposite sides of the converted sheet-shaped plasma in a thickness direction of the sheet-shaped plasma, wherein:
the pressure reducing container includes first and second bottle neck portions that form openings of the film forming chamber, and is formed such that the sheet-shaped plasma flows from the sheet plasma converting chamber through the first bottle neck portion to the film forming chamber, and the flown sheet-shaped plasma flows through the second bottle neck portion to the anode; and
in the thickness direction of the sheet-shaped plasma, an internal size of each of the first and second bottle neck portions is smaller than an internal size of the film forming chamber, and the internal size of the first bottle neck portion is smaller than an internal size of the sheet plasma converting chamber.

2. The sheet plasma film forming apparatus according to claim 1, wherein the first bottle neck portion is formed to have such a cross-sectional shape that the converted sheet-shaped plasma is able to pass through the first bottle neck portion while maintaining a cross-sectional shape of the sheet-shaped plasma.

3. The sheet plasma film forming apparatus according to claim 1, wherein in the thickness direction of the sheet-shaped plasma, a distance between a transport center of the flowing sheet-shaped plasma and at least one of surfaces of the target and the substrate is longer than each of distances between the transport center of the sheet-shaped plasma and an inner wall of the first bottle neck portion and between the transport center of the sheet-shaped plasma and an inner wall of the second bottle neck portion.

4. The sheet plasma film forming apparatus according to claim 3, wherein the distance between the transport center of the sheet-shaped plasma and at least one of the surfaces of the target and the substrate is not less than 10 mm and not more than 200 mm.

5. The sheet plasma film forming apparatus according to claim 1, wherein in the thickness direction of the sheet-shaped plasma, the internal size of the first bottle neck portion is smaller than a sum of a distance between a transport center of the sheet-shaped plasma and a surface of the target and a distance between the transport center of the sheet-shaped plasma and a surface of the substrate, and is not less than 10 mm and not more than 100 mm.

6. The sheet plasma film forming apparatus according to claim 1, further comprising a movement mechanism which causes at least one of the target and the substrate to move in the thickness direction of the sheet-shaped plasma.
